Europäisches Patentamt

European Patent Office

Office européen des brevets

(11) Numéro de publication: **0 421 857 A1**

## (12) DEMANDE DE BREVET EUROPEEN

(21) Numéro de dépôt: **90402707.5**

(22) Date de dépôt: **01.10.90**

(51) Int. Cl.5: **H01L 27/118**

(30) Priorité: **03.10.89 FR 8912892**

(43) Date de publication de la demande:
**10.04.91 Bulletin 91/15**

(84) Etats contractants désignés:
**DE GB NL**

(71) Demandeur: **THOMSON COMPOSANTS MICROONDES**
**51, Esplanade du Général de Gaulle**
**F-92800 Puteaux(FR)**

(72) Inventeur: **Gobbi, José Maria**
**c/o THOMSON-CSF, SCPI, Cédex 67**
**F-92045 Paris La Défense(FR)**
Inventeur: **Le Berre, Louis**
**c/o THOMSON-CSF, SCPI, Cédex 67**
**F-92045 Paris La Défense(FR)**

(74) Mandataire: **Taboureau, James et al**
**THOMSON-CSF SCPI**
**F-92045 Paris La Défense Cédex 67(FR)**

(54) **Circuit électronique intermédiaire prédiffusé.**

(57) L'invention concerne un circuit d'interface, implanté à la périphérie d'un circuit intégré prédiffusé. Il est destiné à adapter les niveaux d'entrée et de sortie vers un circuit extérieur, entre circuits de technologies différentes : BFL, ECL, CMOS...

En vue de rendre cet interface polyvalent, soit en entrée soit en sortie, et adapté à la technologie du circuit extérieur, l'interface comprend une pluralité de composants (9 à 12) et de fonctions (1 à 8) : au moment de la personnalisation du circuit prédiffusé, les composants et fonctions choisis sont métallisés pour les transformer en un interface d'entrée, ou de sortie ou en buffer interne, qui se trouve positionné au meilleur emplacement, avec des jonctions courtes.

Application aux circuits prédiffusés personnalisables.

FIG_7

## CIRCUIT ELECTRONIQUE INTERMEDIAIRE PREDIFFUSE

La présente invention concerne un circuit prédiffusé faisant fonction d'interface entre un autre circuit prédiffusé et son environnement électronique. Le circuit selon l'invention constitue ainsi un intermédiaire d'accès, entrée ou sortie, à un circuit intégré, après avoir reçu les métallisations appropriées. Sa particularité est d'être conçu pour satisfaire les besoins d'interfaces entre plusieurs technologies : ECL, CMOS, BFL, et de pouvoir en outre être utilisé comme amplificateur interne : c'est donc un circuit interface reconfigurable en entrée, en sortie, ou en amplificateur.

Les circuits prédiffusés - s'il s'agit de silicium - ou préimplantés - dans le cas de GaAs ou des matériaux du groupe III-V - sont des circuits inachevés : la zone centrale de la puce supporte une multiplicité de cellules simples, tels que des transistors ou des portes par exemple, mais ces cellules ne sont pas interconnectées par des métallisations. Le réseau d'interconnexions est défini selon l'usage prévu par l'utilisateur du circuit prédiffusé, et réalisé ultérieurement par des métallisations.

Ce type de circuit est préférablement utilisé en logique, et les échanges avec l'électronique environnante se font par l'intermédiaire de circuits d'interfaces qui sont spécialisés, soit en entrée, soit en sortie, et adaptant les niveaux de tensions et de courants selon les gabarits exigés par les différents types de circuits qui travaillent ensemble. Il y a donc une multiplicité de circuits d'interfaces. Si par exemple le circuit prédiffusé est en GaAs et supporte des portes BFL (Buffered FET Logic) et qu'il travaille avec des circuits en silicium de technologies ECL (Emitter Coupled Logic) et CMOS, il faut prévoir six types d'interfaces : trois interfaces d'entrées de ECL, CMOS et BFL vers le circuit prédiffusé BFL, et trois interfaces de sorties du circuit prédiffusé BFL vers les circuits externes ECL, CMOS et BFL.

Ces interfaces ne sont pas des circuits compliqués, mais cela exige cependant six jeux de masques différents. En outre, il se peut toujours que les interfaces qui sont implantés autour de la région centrale du circuit prédiffusé, ne soient pas répartis au mieux : le concepteur dispose d'un interface d'entrée à proximité d'une sortie, par exemple, ce qui exige normalement de modifier les masques.

Le circuit selon l'invention évite ces difficultés. C'est un circuit unique, un peu plus grand en surface occupée sur la puce qu'un interface selon l'art connu, mais il regroupe une pluralité de composants ou fonctions élémentaires, tels que diodes, transistors ou inverseurs, dont la combinaison appropriée de certains d'entre eux permet de réaliser soit un interface d'entrée, soit un interface de sortie, entre plusieurs types de technologies telles que ECL, CMOS, BFL...etc, bien que ces exemples cités ne constituent pas une limitation à la portée de l'invention. L'interconnexion des composants choisis se fait par des niveaux de métallisations, en même temps que l'interconnexion des cellules de la zone centrale du circuit prédiffusé.

Le circuit selon l'invention peut également servir d'amplificateur interne, dit buffer, au circuit prédiffusé : puisqu'il comprend des éléments de puissance, si ceux-ci ne sont pas utilisés, localement, pour un interface d'entrée par exemple, ils peuvent être récupérés pour en faire un buffer qui communique à une cellule du circuit prédiffusé la sortance suffisante pour attaquer une pluralité de cellules suivantes.

Ainsi, le circuit selon l'invention permet de n'utiliser que deux masques pour réaliser un circuit intégré prédiffusé : les masques des cellules de la zone centrale, et les masques des interfaces situés sur le pourtour de la puce. Bien entendu, les métallisations finales nécessitera un jeu de masques personnalisés.

De façon plus précise, l'invention concerne un circuit électronique intermédiaire prédiffusé, servant d'interface d'entrée ou de sortie entre un premier circuit prédiffusé, d'un premier type de technologie (BFL) et un second circuit, d'un second type de technologie (CMOS, ECL), de façon à adapter les niveaux de tensions et de courants entre ces deux circuits, ce circuit intermédiaire étant caractérisé en ce qu'il comporte une pluralité de composants élémentaires, diodes et transistors et de fonctions de protection, de translation de niveaux ou d'amplification avec inversion, dont une partie est choisie et reçoit les métallisations d'interconnexion au cours de la personnalisation du premier circuit prédiffusé, de façon à transformer ce circuit intermédiaire soit en un interface d'entrée, soit en un interface de sortie, soit en un amplificateur interne audit circuit prédiffusé.

L'invention sera mieux comprise par la description détaillée qui suit maintenant d'un exemple de réalisation, appuyée sur les figures jointes en annexe, qui représentent :

- figure 1 : schéma électrique d'un interface d'entrée ECL vers un circuit BFL,
- figure 2 : schéma d'un interface de sortie BFL vers ECL.
- figure 3 : schéma d'un interface d'entrée CMOS vers BFL,
- figure 4 : schéma d'un interface de sortie BFL vers CMOS,
- figure 5 : schéma d'un interface d'entrée BFL vers BFL,

- figure 6 : schéma d'un interface de sortie BFL vers BFL, les six figures précédentes correspondant toutes à l'art connu,
- figure 7 : schéma d'implantation d'un circuit selon l'invention,
- figure 8 : masque des métallisations d'un interface d'entrée ECL,
- figure 9 : masque des métallisations d'un interface d'entrée ECL avec sortie inverseuse,
- figure 10 : masque des métallisations d'un interface de sortie ECL,
- figure 11 : masque des métallisations d'un interface d'entrée CMOS,
- figure 12 : masque des métallisations d'un interface d'entrée BFL,
- figure 13 : masque des métallisations d'un buffer double.

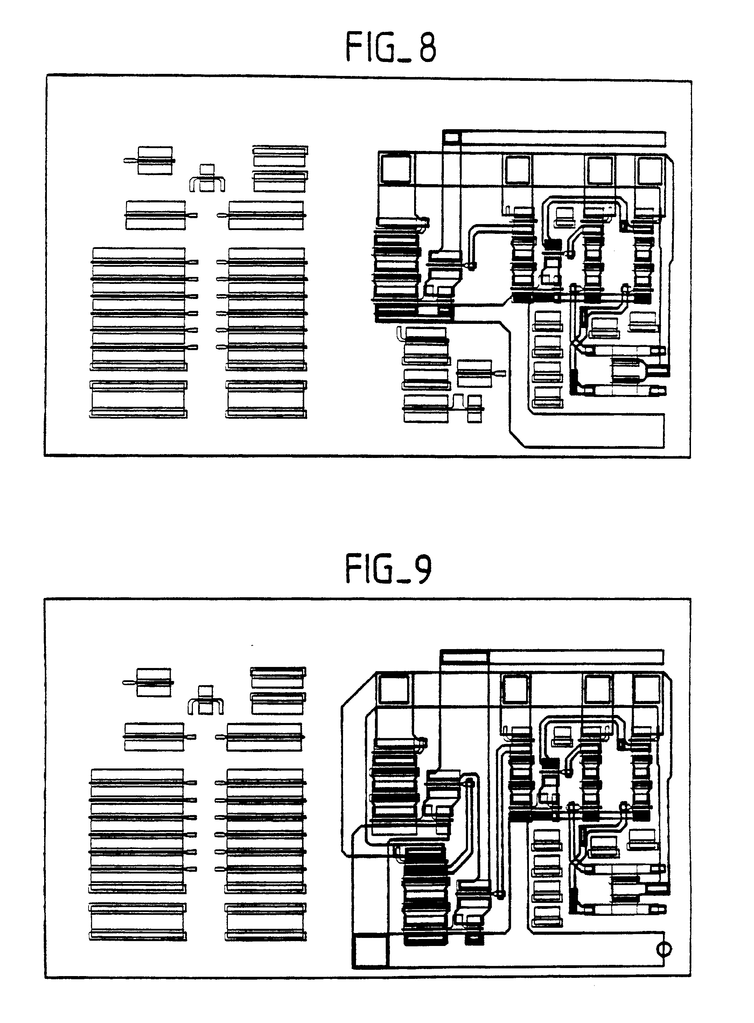

Les six figures 8 à 13 correspondent à l'invention.

Les circuits prédiffusés existent aussi bien sur substrat silicium que sur substrat GaAs ou en matériaux du groupe III-V, bien que dans ce cas il soit plus exact de les nommer préimplantés : de façon à clarifier les explications, l'invention sera exposée en s'appuyant sur l'exemple non limitatif d'un circuit intégré sur GaAs.

De la même façon, un interface est nécessaire chaque fois que coopèrent deux circuits réalisés en technologies différentes : par exemple un circuit silicium ECL avec un circuit GaAs BFL. Dans le même objectif de clarté, l'invention sera exposée en supposant que la zone centrale du circuit prédiffusé est composée de portes BFL. La transposition pour l'homme de l'art est aisée : puisqu'un interface constitue un lien entre deux types de circuits, un interface de sortie BFL vers CMOS, dans un premier circuit intégré, peut également être configurée comme interface d'entrée BFL vers CMOS dans un autre circuit intégré.

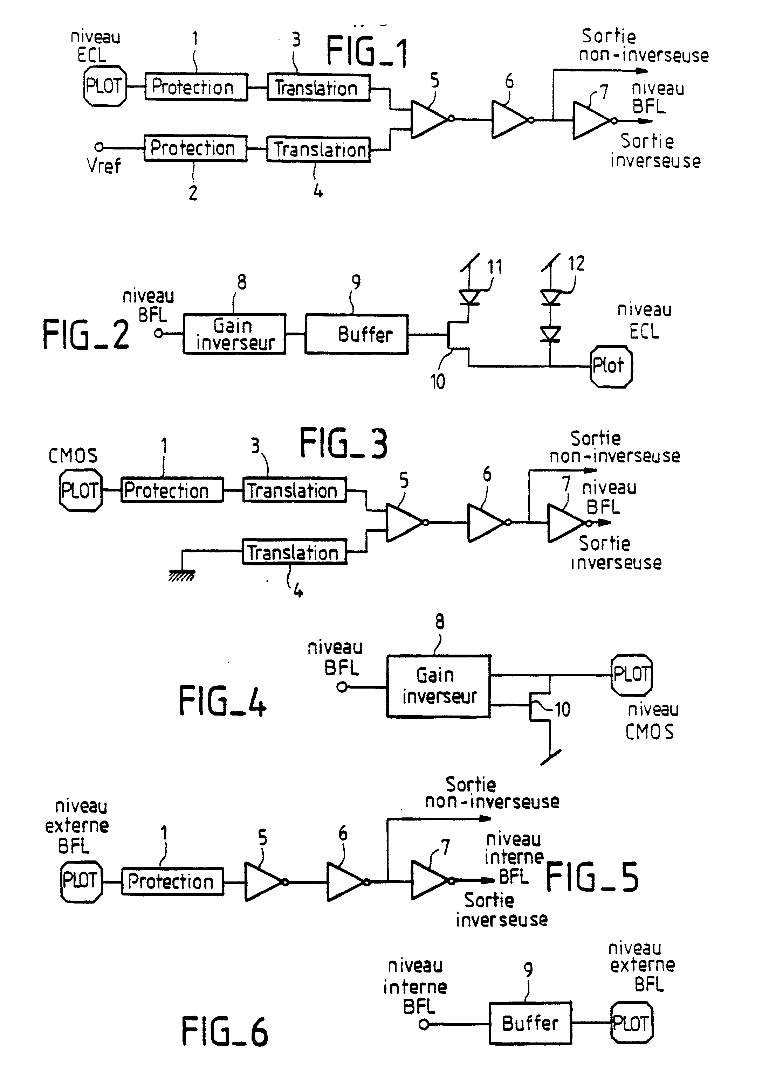

L'adaptation des niveaux de tensions et courants d'un gabarit à un autre gabarit, autrement dit d'interfaçage entre deux technologies, ne nécessite qu'un petit nombre de composants, dont beaucoup se retrouvent dans tous les cas possibles d'interfaces. C'est ce que montrent les figures 1 à 6, qui donnent des schémas électriques connus d'interfaces.

Par exemple, la figure 1 représente un interface d'entrée d'un circuit ECL, au niveau du plot situé sur le pourtour de la puce, vers un circuit BFL, région centrale de la puce. On y trouve, répartis sur une voie de signal et une voie de référence, deux circuits de protection 1 et 2, puis deux circuits de translation de niveaux 3 et 4. Ces deux voies sont comparées dans un premier amplificateur inverseur 5, suivi de deux autres amplificateurs inverseurs 6 et 7, qui servent de buffers au comparateur 5, et délivrent deux sorties, non-inverseuse et inverseuse.

Si le circuit extérieur ECL est remplacé par un circuit CMOS, on voit en figure 3 que l'interface d'entrée est très peu différent : seule la tension de référence de la voie de référence est remplacée par une tension de masse ce qui supprime le circuit de protection 2. Mais le reste de l'interface est identique à celui de la figure 1, et comporte un circuit de protection 1, deux circuits de translation 3 et 4, et trois inverseurs 5,6,7.

Enfin, si ce sont deux circuits BFL qui communiquent, en figure 5, il suffit d'un circuit de protection 1, contre des accidents ou parasites extérieurs. Eventuellement, si la sortance du circuit BPL externe le nécessite, les inverseurs 5,6 et 7, utilisés en buffers, donnent sur les sorties inverseuse et non-inverseuse la puissance requise pour commander les circuits BFL interne.

Inversement, pour sortir d'un circuit BFL, sur la puce du prédiffusé, vers un circuit externe ECL, en figure 2, il faut un amplificateur inverseur 8, suivi d'un buffer 9 et d'un circuit de contrôle d'amplitude composé d'un transistor de puissance 10, d'une diode de puissance 11 et de deux diodes d'écrêtage 12. L'amplificateur inverseur 8 est préférablement différent des inverseurs 5,6,7 des interfaces d'entrées : les niveaux de puissances n'y sont pas les mêmes, et les transistors sont plus gros, de même que pour le buffer 9.

Mais cet amplificateur inverseur 8 et le transistor de puissance 10 se retrouvent dans l'interface de sortie d'un circuit BFL vers un circuit CMOS, en figure 4, tandis que le buffer 9 est utilisé, seul, dans un interface de sortie BFL vers BFL, représenté en figure 6.

Ainsi, les différentes interfaces d'entrées et de sorties entre circuits de technologies BFL, ECL et CMOS nécessitent en tout :

- deux circuits de protection 1 et 2,
- deux circuits de translation de niveaux 3 et 4,
- trois inverseurs 5,6, et 7,
- un inverseur de puissance 8,
- un buffer 9,
- un transistor de puissance 10,
- une diode de puissance 11,
- deux diodes écrêteuses 12.

Le circuit selon l'invention regroupe ces composants ou fonctions en un seul macrocomposant, qui est diffusé ou implanté à la périphérie du circuit prédiffusé, à proximité immédiate des plots de raccordement aux connexions d'accès. Le choix des composants et fonctions utilisés est laissé à l'utilisateur, et le masque des métallisations nécessaires est conçu en même temps que le masque de personnalisation du circuit prédiffusé, qui devient alors un circuit intégré "à la demande".

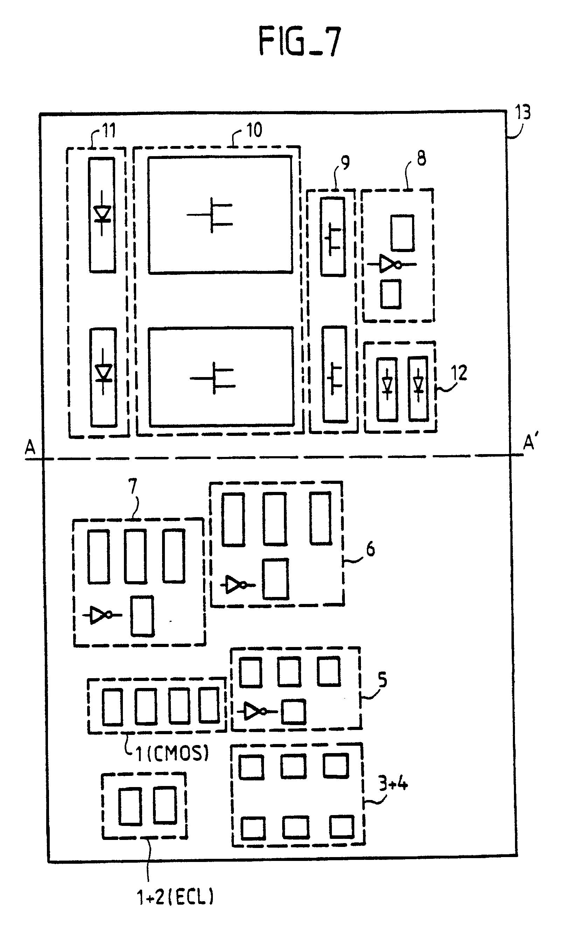

Le schéma général d'implantation du circuit selon l'invention est représenté en figure 7. Les composants y sont représentés sous forme de rectangles, correspondant à la surface occupée sur la puce de matériau semiconducteur, et les fonctions regroupées à l'intérieur d'un trait pointillé.

L'intérieur d'un cadre 13, qui correspond à la surface occupée par le circuit selon l'invention, est divisé par une ligne AA$'$ en deux parties : d'un côté de cette ligne sont regroupés les composants de puissance ou de sorties, et de l'autre côté les composants de signal ou les fonctions d'entrées.

Dans la partie puissance, les composants sont, pour la plupart, divisés en deux, ce qui permet de moduler la puissance délivrée. Elle comprend :
- deux diodes qui, mises en parallèle, fournissent la diode de puissance 11 en série avec le transistor 10, dans l'interface de sortie BFL vers ECL,
- un transistor de puissance 10, interdigité,
- deux transistors, pour former les buffers de sortie 9,
- un inverseur 8, qui fournit l'étage inverseur avec gain,
- deux diodes écrêteuses 12.

Le transistor de puissance est divisé en deux : cela permet, selon les puissances requises, d'en utiliser une partie dans un interface de sortie et une autre partie comme buffer interne au circuit prédiffusé, par exemple. En outre, chaque partie de ce transistor 10 de puissance est elle-même composée d'une pluralité de petits transistors interdigités : on obtient la puissance voulue en métallisant le nombre nécessaire de plages de contact de sources, grilles et drains et, si besoin, en faisant travailler les deux parties du transistor en parallèle.

Dans la partie de signaux sont implantées ;
- les protections d'entrées 1/2, formées chacune de deux transistors et une diode,
- les circuits de translations 3 et 4 formés chacun de deux transistors et d'une pluralité de diodes en série,
- trois amplificateurs inverseurs 5,6 et 7.

L'implantation des divers composants et fonctions, à l'intérieur du cadre 13, n'est pas limitée par la représentation qui en est donnée en figure 7 : les blocs pouvant être disposés autrement selon les nécessités de la conception du masque de métallisation finale. Cependant, cette implantation obéit à un certain nombre de règles :
- les fonctions, ou les composants divisés en deux parties (9,10,11) restent groupés, pour simplifier les futures métallisations,
- les blocs sont disposés de façon suffisamment lâche pour que des pistes métallisées puissent être déposées entre eux, ces pistes étant rectilignes autant que possible, plutôt que sinueuses, ce qui est favorable en hyperfréquences. Dans leur ensemble, les pistes métalliques de transport des signaux sont disposées longitudinalement sur la figure 7.

- les parties de signaux et de puissance sont séparées par une zone assez large pour que passent toutes les pistes métallisées qui distribuent les tensions d'alimentation : $V_{SS}$, $V_{DD}$, $V_{RR}$, $V_{Ref}$... etc. Ces pistes métallisées transversales sur la figure 7 et parallèles à la ligne AA$'$, sont recouvertes par une couche isolante qui permet aux précédentes pistes conductrices de les couper à angle droit, ou de s'y raccorder par un puits dans la couche isolante.

Le circuit selon l'invention présente de nombreux avantages. Deux masques seulement sont suffisants pour réaliser un circuit personnalisable : le masque des cellules de la zone centrale et le masque des interfaces. Ceux-ci sont disposés sur le pourtour de la puce, à proximité des plots métalliques de câblage qui servent aussi de dissipateurs thermiques aux transistors de puissance. A ce stade de fabrication, les interfaces ne sont pas spécifiés : on ne sait pas encore si un circuit donné sera interconnecté en interface d'entrée, ou en interface de sortie, ou utilisé en buffer interne.

Le concepteur qui personnalise le circuit prédiffusé peut donc choisir l'interface le plus proche pour en faire un interface d'entrée, ou de sortie, et dessiner le masque des métallisations d'interconnexions en conséquence : les liaisons entre les cellules et les interfaces sont courtes.

Les figures suivantes donnent quelques exemples d'utilisation du circuit selon l'invention par des métallisations appropriées.

Les figures 8 et 9 montrent des interfaces d'entrée ECL, respectivement avec sortie non-inverseuse (8) et avec sortie inverseuse (9). L'ensemble de la partie puissance est inutilisé, et l'inverseur 7 n'est pas câblé dans le cas de l'interface avec sortie non-inverseuse seulement.

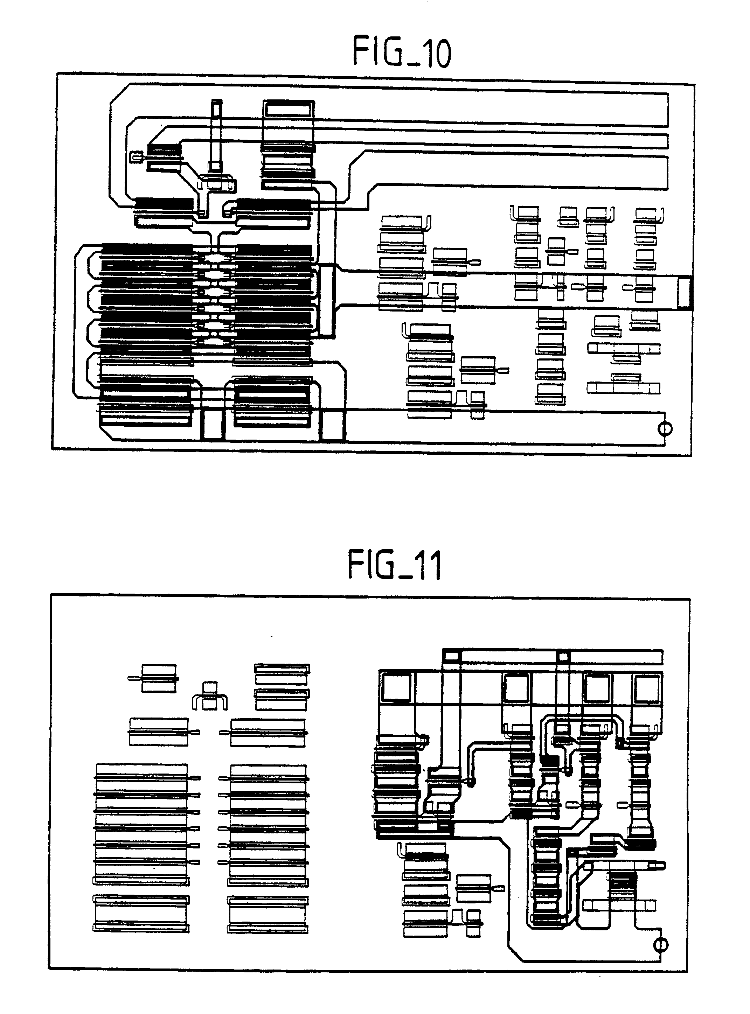

La figure 10 montre un interface de sortie ECL : la partie puissance est intégralement utilisée, et la partie signaux n'est pas câblée. Celle-ci pourrait éventuellement être employée comme interface d'entrée ECL pour une cellule voisine, si un plot est disponible.

La figure 11 représente un interface d'entrée CMOS. Elle est comparable à la figure 8, mais les circuits de protection d'entrée sont légèrement différents.

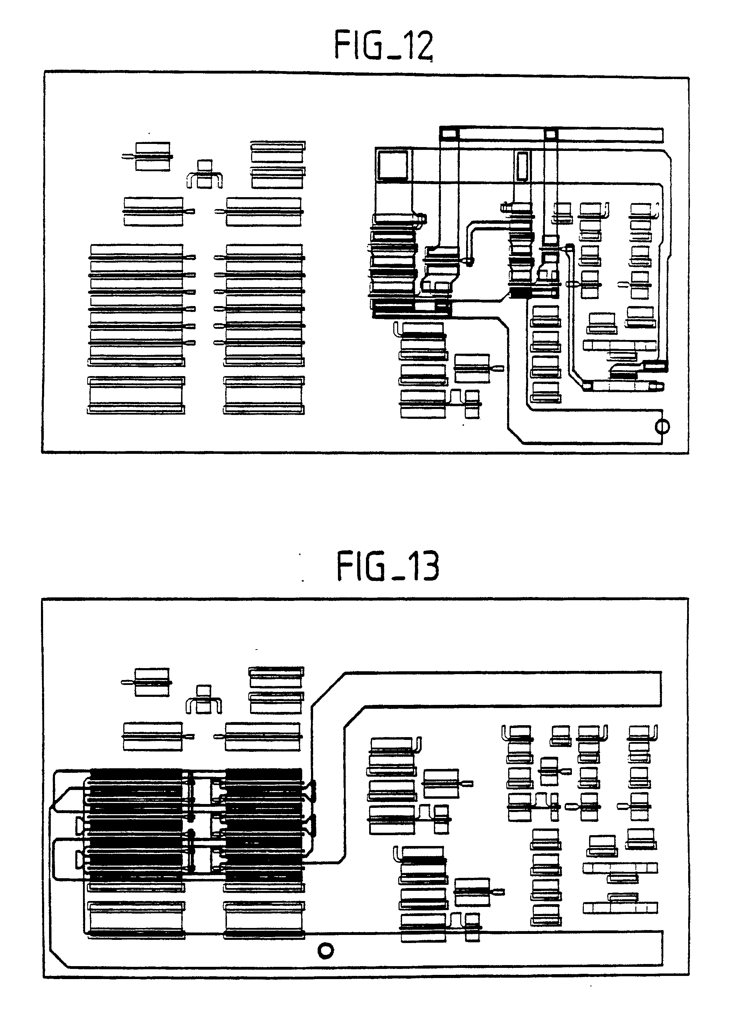

Sur la figure 12, interface d'entrée BFL, seuls le circuit de protection 1, contre des parasites extérieurs, et les inverseurs 5 et 6, pour donner du gain nu signal d'entrée, sont métallisés.

Enfin, en figure 13, le circuit selon l'invention est utilisé en buffer double : il permet à une cellule du circuit prédiffusé, qui a une sortance insuffisante, d'attaquer une pluralité de cellules, dans une étage suivant du circuit prédiffusé, ou de sortie vers un autre circuit intégré.

L'invention a été décrite en s'appuyant sur l'exemple d'un circuit prédiffusé de type BFL en GaAs. Il est évident pour l'homme de l'art qu'elle s'applique à d'autres types de circuits, sur silicium ou d'autres matériaux du groupe III-V.

**Revendications**

1. Circuit électronique intermédiaire prédiffusé, servant d'interface d'entrée ou de sortie entre un premier circuit prédiffusé, d'un premier type de technologie (BFL) et un second circuit, d'un second type de technologie (CMOS, ECL), de façon à adapter les niveaux de tensions et de courants entre ces deux circuits, ce circuit intermédiaire étant caractérisé en ce qu'il comporte une pluralité de composants élémentaires (9 à 12) et une pluralité de fonctions (1 à 7), ces deux pluralités étant réparties en trois zones à la surface du circuit prédiffusé : une première zone regroupe les fonctions d'entrée dans un interface, circuits de protection (1,2) et de translation (3,4) et circuits d'amplification-inversion (5,6,7), une seconde zone centrale permet le passage des métallisations de personnalisation du circuit, et une troisième zone regroupe les fonctions de sortie de l'interface, diodes (11,12) et transistors (9,10) de puissance, et amplificateur de sortie (8).

2. Circuit intermédiaire selon la revendication 1, caractérisé en ce qu'une partie des composants et/ou fonctions est choisie et reçoit les métallisations d'interconnexion au cours de la personnalisation du premier circuit prédiffusé, de façon à transformer ce circuit intermédiaire soit en un interface d'entrée, soit en un interface de sortie, soit en un amplificateur interne audit circuit prédiffusé. .

3. Circuit intermédiaire selon la revendication 1, caractérisé en ce que les composants élémentaires (9 à 12) et les fonctions (1 à 7) sont regroupés en blocs séparés par des gardes, prévus pour le passage de métallisations de personnalisation linéaires.

4. Circuit intermédiaire selon la revendication 3, caractérisé en ce que les composants et fonctions y sont implantés de telle façon que les métallisations qui sont déposées au cours de la personnalisation du circuit prédiffusé soient des lignes droites, qui passent entre les blocs de fonctions.

5. Circuit intermédiaire selon la revendication 3, caractérisé en ce que au moins un transistor de puissance (10), dans la zone des composants de puissance, est constitué d'une pluralité de transistors interdigités, dont une partie reçoit les métallisations nécessaires en fonction de la puissance requise.

6. Circuit intermédiaire selon la revendication 5, caractérisé en ce que, en vue de donner à un étage du circuit prédiffusé la sortance nécessaire pour attaquer un autre étage dudit circuit prédiffusé, seuls les transistors de puissance (10) sont métallisés pour en faire un amplificateur interne, les fonctions d'interface d'entrée et d'interface de sortie étant inutilisées pour des étages considérés du circuit prédiffusé.

## FIG_1

niveau ECL

PLOT — Protection (1) — Translation (3) — (5) — (6) — (7) — Sortie non-inverseuse — niveau BFL — Sortie inverseuse

Vref — Protection (2) — Translation (4)

## FIG_2

niveau BFL — Gain inverseur (8) — Buffer (9) — (10) — (11) (12) — niveau ECL — Plot

## FIG_3

CMOS

PLOT — Protection (1) — Translation (3) — (5) — (6) — (7) — Sortie non-inverseuse — niveau BFL — Sortie inverseuse

Translation (4)

## FIG_4

niveau BFL — Gain inverseur (8) — (10) — PLOT — niveau CMOS

## FIG_5

niveau externe BFL

PLOT — Protection (1) — (5) — (6) — (7) — Sortie non-inverseuse — niveau interne BFL — Sortie inverseuse

## FIG_6

niveau interne BFL — Buffer (9) — PLOT — niveau externe BFL

# FIG_7

# FIG_8

# FIG_9

## FIG_10

## FIG_11

## FIG_12

## FIG_13

Office européen
des brevets

**RAPPORT DE RECHERCHE
EUROPEENNE**

Numéro de la demande

**EP 90 40 2707**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 023 118 (FUJITSU LTD) <br> * Revendications 1,3-4; page 4, lignes 17-33; page 7, ligne 9 - page 8, ligne 25; figures 2,11-14 * <br> ‒ ‒ ‒ | 1-2,6 | H 01 <br> L 27/118 |
| A | IEEE JOURNAL OF SOLID-STATE CIRCUITS, vol. SC-19, no. 1, février 1984, pages 10-22, New York, US; T.T. VU et al.: "A gallium arsenide SDFL gate array with on-chip RAM" <br> * Page 14, colonne de gauche, alinéa 2 - page 15, colonne de gauche, alinéa 1; figures 14-18; table V * <br> ‒ ‒ ‒ | 1-2 | |
| A | PATENT ABSTRACTS OF JAPAN, vol. 8, no. 155 (E-256)[1592], 19 juillet 1984; <br> & JP-A-59 058 840 (MITSUBISHI DENKI K.K.) 04-04-1984 <br> * Résumé; figures * <br> ‒ ‒ ‒ ‒ ‒ | 1-2 | |

DOMAINES TECHNIQUES
RECHERCHES (Int. Cl.5)

H 01 L 27

Le présent rapport de recherche a été établi pour toutes les revendications

| Lieu de la recherche | Date d'achèvement de la recherche | Examinateur |
|---|---|---|
| La Haye | 02 décembre 90 | FRANSEN L.J.L. |